# EUROPÄISCHE PATENTSCHRIFT

(11) **EP 1 019 946 B1**
(45) Veröffentlichungstag und Bekanntmachung des Hinweises auf die Patenterteilung: **17.09.2003**
(21) Anmeldenummer: 99950450.9
(22) Anmeldetag: 30.07.1999
(51) Int. Cl.: H01J 37/34

(54) **VORRICHTUNG ZUM BESCHICHTEN VON PLATTENFÖRMIGEN SUBSTRATEN**
DEVICE FOR COATING PANEL-SHAPED SUBSTRATES
DISPOSITIF DE REVETEMENT DE SUBSTRATS EN FORME DE PANNEAUX

(30) Priorität: 31.07.1998 DE 19834592
(43) Veröffentlichungstag der Anmeldung: 19.07.2000
(73) Patentinhaber: Applied Films GmbH & Co. KG, 63755 Alzenau (DE)
(72) Erfinder: SCHUHMACHER, Manfred, D-63755 Alzenau-Michelbach (DE); SAUER, Andreas, D-63768 Hösbach (DE); GRUNDMANN, Katja, D-63512 Hainburg (DE)
(74) Vertreter: Schlagwein, Udo, Dipl.-Ing.
(86) Internationale Anmeldenummer: DE9902326
(87) Internationale Veröffentlichungsnummer: WO00008671

(56) Entgegenhaltungen:
- DE-A- 4 225 531
- DE-A- 19 540 053
- DE-A- 19 646 700
- DE-A- 19 733 940

## Beschreibung

Die Erfindung betrifft eine Vorrichtung zum Beschichten von plattenförmigen Substraten durch Kathodenzerstäubung, welche hintereinander mehrere Prozesskammern hat, die nach oben hin jeweils durch eine Kammerdecke begrenzt sind, welche jeweils eine Öffnung hat, die von einem zumindest eine Kathode tragenden Deckel abgedeckt ist und bei der die Prozesskammer Blenden und Versorgungsleitungen, insbesondere Kühlmittelleitungen aufweist.

Vorrichtungen der vorstehenden Art werden in der Technik zur Beschichtung plattenförmiger Substrate häufig eingesetzt und sind allgemein bekannt. Bei ihnen sind die Kathoden und weitere Kammereinbauten, insbesondere die Blenden und Kühlmittelleitungen, fest in der Prozesskammer installiert. Das hat den Nachteil, dass die Demontage von Anlageteilen aufwendig ist und zu unerwünscht langen Stillstandszeiten führt, wenn zu Reinigungszwecken Teile ausgebaut und wieder eingebaut werden müssen.

Der Erfindung liegt das Problem zugrunde, eine Vorrichtung der eingangs genannten Art zum Beschichten von plattenförmigen Substraten derart zu gestalten, dass ihre Kathoden und Kammereinbauten möglichst rasch demontiert und wieder montiert werden können.

Dieses Problem wird erfindungsgemäß dadurch gelöst, dass die Blenden und Versorgungsleitungen, insbesondere Kühlmittelleitungen an einem in die Prozesskammer ragenden, nach oben hin aus der Öffnung herausziehbaren Gestell vorgesehen sind, welches mit Abstützteilen auf Auflageflächen der Kammerdecke abgestützt ist und dass der Deckel die Abstützteile überragt und von oben her unmittelbar dichtend auf der Kammerdecke aufsitzt.

Durch diese Gestaltung wird es möglich, mit dem Deckel und dem Gestell alle Teile der Beschichtungsstation nach oben hin aus der Prozesskammer herauszuziehen und rasch gegen ein zweites Gestell und eine zweite Kathodenanordnung auszuwechseln oder die ausgebauten Teile rasch zu reinigen und durch Einfahren des Gestells und des Deckels mit den Kathoden wieder zu montieren. Durch die Erfindung ergeben sich deshalb besonders geringe Stillstandszeiten der Beschichtungsvorrichtung. Weil der Deckel die Abstützteile überragt und unmittelbar auf der Kammerdecke aufsitzt, muss nur dieser gegenüber der Kammerdecke abgedichtet werden.

Der die Kathoden tragende Deckel kann völlig flach ausgebildet sein, wenn gemäß einer Weiterbildung der Erfindung die Auflageflächen innerhalb der Öffnung durch Abstufungen innerhalb zweier, die Öffnung jeweils längsseitig begrenzenden Randbereichen vorgesehen sind. Bei einer solchen Ausbildung ragt das Gestell nicht nach oben aus der Öffnung heraus.

Eine andere, vorteilhafte Weiterbildung der Erfindung besteht darin, dass das Gestell an einer Längsseite einen über die Prozesskammer greifenden Ausleger mit Versorgungsanschlüssen zumindest für Kühlmittel hat. Durch diese Gestaltung entfallen innerhalb der Prozesskammer befindliche, beim Ausbau von Einbauteilen zu lösende Kühlmittelverbindungen, wodurch die Gefahr eines Austritts von Kühlmittel innerhalb der Prozesskammer infolge nicht dichter Verbindungen entfällt.

Beim Einsetzen des Gestells in die Prozesskammer können die Versorgungsanschlüsse selbsttätig mit entsprechenden Zuführanschlüssen kuppeln, wenn die Versorgungsanschlüsse nach unten gerichtet und außenseitig an der Prozesskammer Kühlmittelzuführanschlüsse angeordnet sind, welche mit den Versorgungsanschlüssen des Auslegers fluchten. Die Kühlmittelzuführanschlüsse können Stoppventile aufweisen, die automatisch schließen, sobald man das Gestell anhebt und deshalb die Versorgung unterbrochen werden muss. Auch die erforderlichen elektrischen Verbindungen und die Prozessgasverbindung können über diesen Ausleger führen.

Eine Überhitzung der Blenden kann auf besonders einfache Weise und ohne Erhöhung des Aufwandes bei der Demontage und Montage der Blenden vermieden werden, wenn die Blenden mit dem Kühlmittel verbindbare Kühlwasserrohre aufweisen.

Dabei ist es besonders vorteilhaft, wenn die Blenden kastenförmig ausgebildet sind und zwischen zwei Transportrollen nahe der Mantelflächen dieser Transportrollen verlaufende Bereiche aufweisen. Solche gekühlten Blenden vermögen die Strahlungswärme der in ihrer unmittelbaren Nachbarschaft angeordneten Transportrollen aufzunehmen und abzuführen.

Die Verbindung der Blenden mit dem Kühlmittel innerhalb des Gestells kann ohne Gefahr eines Kühlmitteleintritts in die Prozesskammer bei Undichtigkeiten der Kühlmittelleitungen auf besonders einfache Weise erfolgen, wenn gemäß einer anderen Weiterbildung der Erfindung das Gestell an der Seite des Auslegers einen mit der Atmosphäre in Verbindung stehenden, zur Prozesskammer hin abgeschlossenen Versorgungsraum aufweist, in welchem der Kühlmittelverbindung zu den Blenden dienende Schläuche angeordnet sind.

Eine Nebenströmung des Prozessgases außenseitig am Gestell vorbei anstatt in den Beschichtungsbereich kann man dadurch verhindern, dass das Gestell nahe der Blenden an seiner Unterseite gegenüber einem Zwischenboden der Prozesskammer durch Quetschdichtungen abgedichtet ist.

Die Zuführung des Prozessgases kann ebenfalls ohne Anschlüsse innerhalb der Prozesskammer erfolgen, wenn gemäß einer anderen Weiterbildung der Erfindung der Deckel Gasrohre für die Zuführung des Prozessgases und über die Prozesskammer greifende Gasanschlüsse hat und wenn die Prozesskammer außenseitig mit den Gasanschlüssen fluchtende Gaszuführanschlüsse aufweist.

Günstig ist es auch, wenn das Gestell mit dem Deckel der Kathodenanordnung mechanisch gekoppelt ist. Bei einer solchen Ausführungsform wird mit dem Abheben der Kathodenanordnung zugleich das Gestell aus der Prozesskammer gezogen.

Die Erfindung lässt verschiedene Ausführungsformen zu. Eine davon ist in der Zeichnung dargestellt und wird nachfolgend beschrieben. Diese zeigt in
- Fig.1: einen Querschnitt durch eine Beschichtungsanlage nach der Erfindung,
- Fig.2: eine Vorderansicht einer Kathodeneinheit,
- Fig.3: eine Vorderansicht eines Gestells der Beschichtungsanlage,
- Fig.4: eine Seitenansicht der Kathodeneinheit,
- Fig.5: einen Längsschnitt durch einen Teilbereich der Beschichtungsanlage, in Bewegungsrichtung der zu beschichtenden Substrate gesehen.

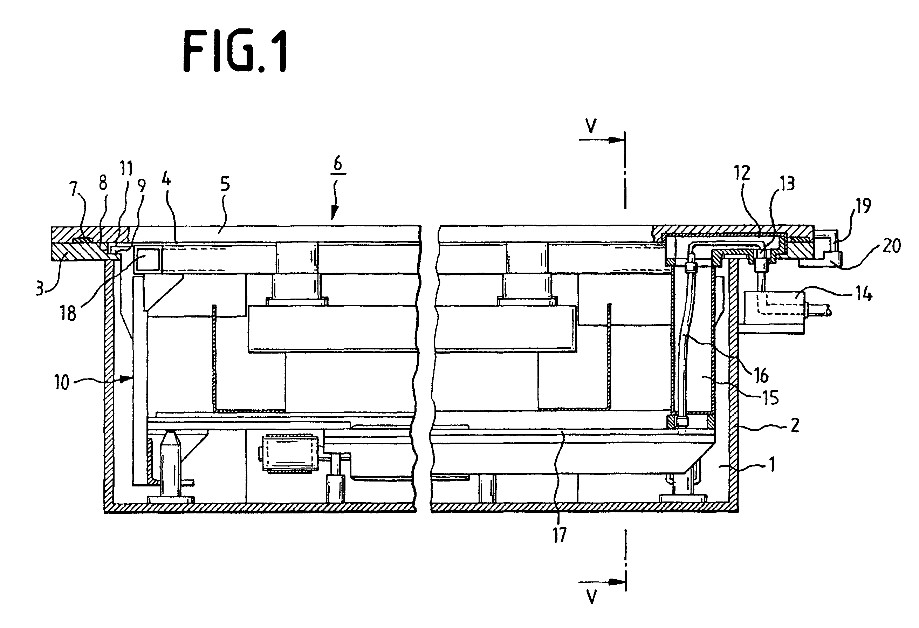

Die Figur 1 zeigt einen Querschnitt durch eine Prozesskammer 1 einer Beschichtungsanlage. Diese Prozesskammer 1 hat ein Kammergehäuse 2, welches nach oben hin durch eine Kammerdecke 3 abgedeckt ist. Diese Kammerdecke 3 weist eine Öffnung 4 auf, die nach oben hin durch einen Deckel 5 einer Kathodenanordnung 6 verschlossen ist. Eine Dichtung 7 dichtet diesen Deckel 5 gegenüber der Kammerdecke 3 ab. Die Kammerdecke 3 weist zur Öffnung 4 hin Abstufungen 8 auf, durch welche Auflageflächen 9 entstehen.

Innerhalb der prozesskammer 1 ist ein Gestell 10 angeordnet, welches sich mit Abstützteilen 11 auf den Auflageflächen 9 der Öffnung 4 derart abstützt, dass das Gestell 10 die Kammerdecke 3 nicht nach oben hin überragt. Dadurch wird erreicht, dass der Deckel 5 sich unmittelbar auf der Kammerdecke 3 abstützt.

Wie die Figur 1 ebenfalls erkennen lässt, greift das Gestell 10 an einer Längsseite der Prozesskammer 1 mit einem Ausleger 12 über ihr Kammergehäuse 2. Dieser Ausleger 12 weist nach unten gerichtete Versorgungsanschlüsse 13 auf, welche mit an der Außenseite des Kammergehäuses 2 vorgesehenen Kühlmittel-Zuführanschlüssen 14 fluchten und im eingebauten Zustand des Gestells 10 miteinander verbunden sind. An der Seite des Auslegers 12 hat das Gestell 10 einen zur Prozesskammer 1 hin abgedichteten Versorgungsraum 15, in welchem Kühlmittelleitungen 16 verlaufen, welche Blenden 17 über die Versorgungsanschlüsse 13 mit Kühlmittel verbinden.

Unterhalb des Deckels 5 sind an diesem Gasrohre 18 befestigt, welche der Zufuhr des Prozessgases dienen. Die Zufuhr dieses Prozessgases erfolgt ähnlich wie die des Kühlmittels über einen Gasanschluss 19, der seitlich über die Prozesskammer 1 ragt und dort mit einem Gaszuführanschluss 20 Verbindung hat.

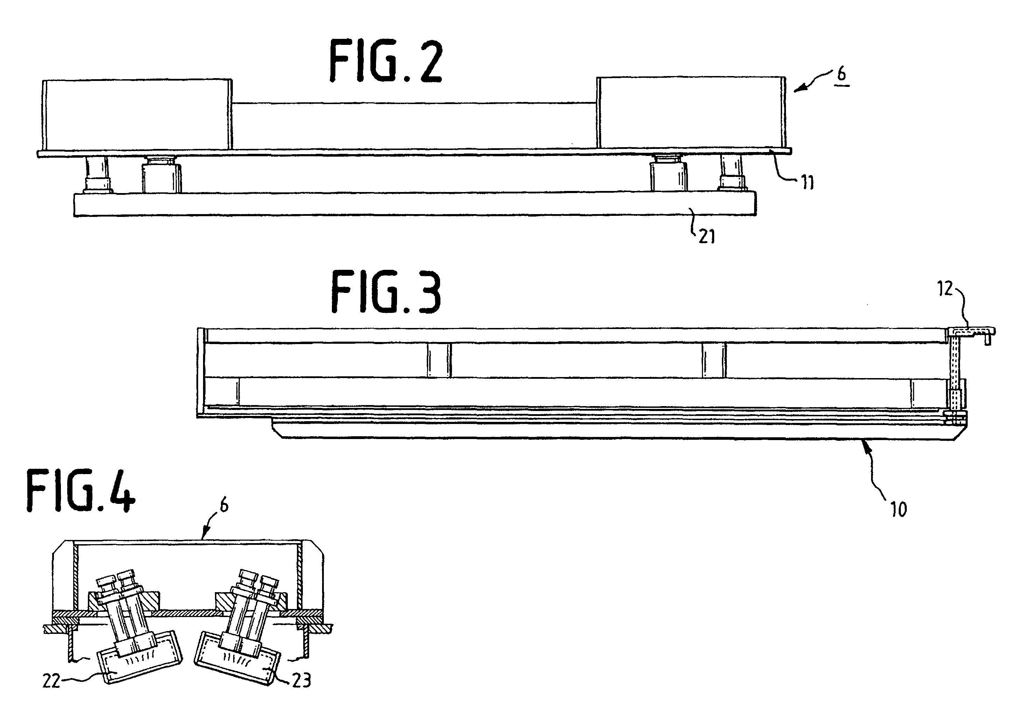

Die Figur 2 zeigt die Kathodenanordnung 6 als Einzelteil. Sie weist unterhalb des Deckels 5 ein Target 21 auf.

In Figur 3 wurde das Gestell 10 als Einzelteil dargestellt. Zu erkennen ist wiederum der Ausleger 12, über welchen die Zufuhr des Kühlmittels erfolgt.

Der Figur 4 ist zu entnehmen, dass bei dem gezeigten Ausführungsbeispiel die Kathodenanordnung 6 insgesamt zwei Kathoden 22, 23 trägt.

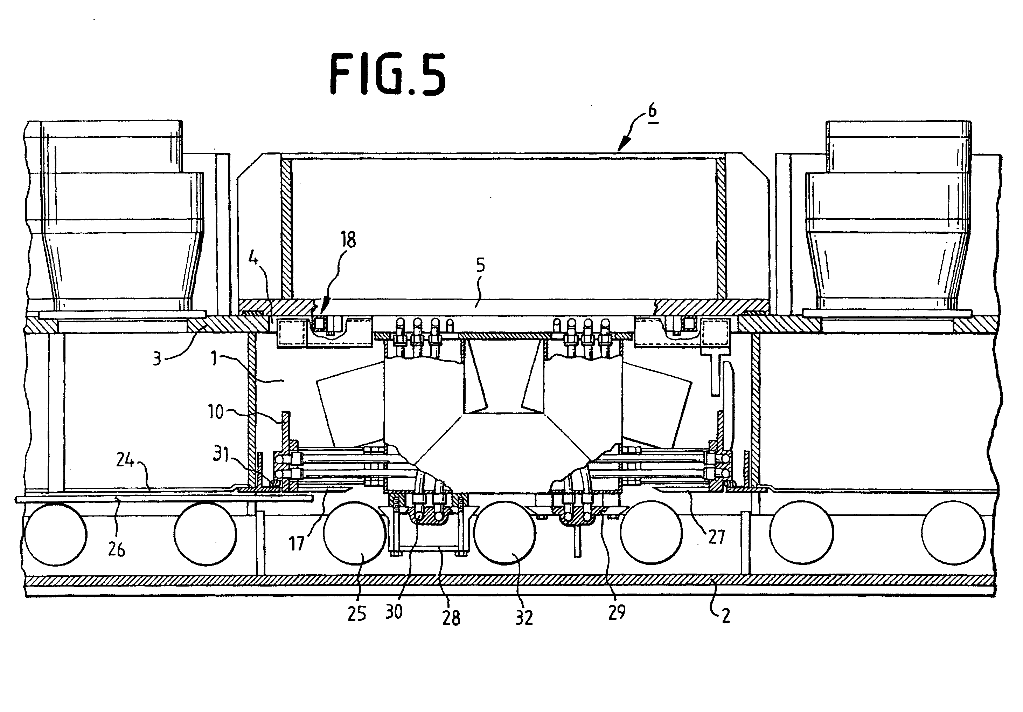

In der Figur 5 ist zu sehen, dass die Prozesskammer 1 unterhalb eines Zwischenbodens 24 Transportrollen 25, 32 aufweist, durch die die zu beschichtenden Substrate durch die einzelnen Prozesskammern 1 gefahren werden. Zu erkennen ist, dass außer der schon in Figur 1 positionierten Blende 17 weitere Blenden 27, 28, 29 vorgesehen sind, welche jeweils Kühlwasserrohre 30 aufweisen, um durch das Kühlmedium wirksam gekühlt werden zu können. Die Blende 28 ist kastenförmig ausgebildet und weist zwischen den beiden angrenzenden Transportrollen 25, 32 nahe der Mantelflächen dieser Transportrollen 25, 32 verlaufende Bereiche auf. Dadurch ist die Blende 28 besonders gut in der Lage, abgestrahlte Wärme dieser Transportrollen 25, 32 aufzunehmen.

Quetschdichtungen 31 dichten das Gestell 10 an seiner Unterseite gegen den Zwischenboden 24 ab, so dass Nebenströmungen des aus den Gasrohren 18 austretenden Prozessgases vermieden werden.

Nicht dargestellt ist eine Ausführungsform, bei der das Gestell 10 mit dem Deckel 5 der Kathodenanordnung 6 mechanisch gekoppelt ist. Bei einer solchen Ausführungsform kann man alle Versorgungsleitungen vom Gestell 10 durch den Deckel 5 hindurch führen. Sie hat den Vorteil, dass mit dem Abheben der Kathodenanordnung 6 zugleich das Gestell 10 mit aus der Prozesskammer 1 gehoben wird.

### Bezugszeichenliste

- 1: Prozesskammer
- 2: Kammergehäuse
- 3: Kammerdecke
- 4: Öffnung
- 5: Deckel

- 6: Kathodenanordnung
- 7: Dichtung
- 8: Abstufung
- 9: Auflagefläche
- 10: Gestell

- 11: Abstützteil
- 12: Ausleger
- 13: Versorgungsanschluss
- 14: Kühlmittel-Zuführanschluss
- 15: Versorgungsraum

- 16: Kühlmittelleitung
- 17: Blende
- 18: Gasrohr
- 19: Gasanschluss
- 20: Gaszuführanschluss

- 21: Target
- 22: Kathode
- 23: Kathode
- 24: Zwischenboden
- 25: Transportrolle

- 26: Substrat
- 27: Blende
- 28: Blende
- 29: Blende
- 30: Kühlwasserrohre

- 31: Quetschdichtung
- 32: Transportrolle

## Patentansprüche

1. Vorrichtung zum Beschichten von plattenförmigen Substraten durch Kathodenzerstäubung, welche hintereinander mehrere Prozesskammern hat, die nach oben hin jeweils durch eine Kammerdecke begrenzt sind, welche jeweils eine Öffnung hat, die von einem zumindest eine Kathode tragenden Deckel abgedeckt ist und bei der die Prozesskammer Blenden und Versorgungsleitungen, insbesondere Kühlmittelleitungen aufweist, **dadurch gekennzeichnet, dass** die Blenden (17, 27, 28, 29) und Versorgungsleitungen, insbesondere Kühlmittelleitungen (16) an einem in die Prozesskammer (1) ragenden, nach oben hin aus der Öffnung (4) herausziehbaren Gestell (10) vorgesehen sind, welches mit Abstützteilen (11) auf Auflageflächen (9) der Kammerdecke (3) abgestützt ist und dass der Deckel (5) die Abstützteile (11) überragt und von oben her unmittelbar dichtend auf der Kammerdecke (3) aufsitzt.

2. Vorrichtung nach Anspruch 1, **dadurch gekennzeichnet, dass** die Auflageflächen (9) innerhalb der Öffnung (4) durch Abstufungen (8) innerhalb zweier, die Öffnung (4) jeweils längsseitig begrenzenden Randbereichen vorgesehen sind.

3. Vorrichtung nach den Ansprüchen 1 oder 2, **dadurch gekennzeichnet, dass** das Gestell (10) an einer Längsseite einen über die Prozesskammer (1) greifenden Ausleger (12) mit Versorgungsanschlüssen (13) zumindest für Kühlmittel hat.

4. Vorrichtung nach Anspruch 3, **dadurch gekennzeichnet, dass** die Versorgungsanschlüsse (13) nach unten gerichtet und außenseitig an der Prozesskammer (1) Kühlmittel-Zuführanschlüsse (14) angeordnet sind, welche mit den Versorgungsanschlüssen (13) des Auslegers (12) fluchten.

5. Vorrichtung nach zumindest einem der vorangehenden Ansprüche, **dadurch gekennzeichnet, dass** die Blenden (17, 27, 28, 29) mit dem Kühlmittel verbindbare Kühlwasserrohre (30) aufweisen.

6. Vorrichtung nach Anspruch 5, **dadurch gekennzeichnet, dass** die Blenden (28) kastenförmig ausgebildet sind und zwischen zwei Transportrollen (25, 32) nahe der Mantelflächen dieser Transportrollen verlaufende Bereiche aufweisen.

7. Vorrichtung nach zumindest einem der vorangehenden Ansprüche, **dadurch gekennzeichnet, dass** das Gestell (10) an der Seite des Auslegers (12) einen mit der Atmosphäre in Verbindung stehenden, zur Prozesskammer (1) hin abgeschlossenen Versorgungsraum (15) aufweist, in welchem die der Kühlmittelverbindung zu den Blenden (17, 27, 28, 29) dienende Kühlmittelleitungen (16) angeordnet sind.

8. Vorrichtung nach zumindest einem der vorangehenden Ansprüche, **dadurch gekennzeichnet, dass** das Gestell (10) nahe der Blenden (17, 27, 28, 29) an seiner Unterseite gegenüber einem Zwischenboden (24) der Prozesskammer (1) durch Quetschdichtungen (31) abgedichtet ist.

9. Vorrichtung nach zumindest einem der vorangehenden Ansprüche, **dadurch gekennzeichnet, dass** der Deckel (5) Gasrohre (18) für die Zuführung des Prozessgases und über die Prozesskammer (1) greifende Gasanschlüsse (19) hat und dass die Prozesskammer (1) außenseitig mit den Gasanschlüssen (19) fluchtende Gaszuführanschlüsse (20) aufweist.

10. Vorrichtung nach zumindest einem der vorangehenden Ansprüche, **dadurch gekennzeichnet, dass** das Gestell (10) mit dem Deckel (5) der Kathodenanordnung (6) mechanisch gekoppelt ist.

## Claims

1. A device for coating panel-shaped substrates by cathodic sputtering, said device having several process chambers in series which are each delimited in the upward direction by a chamber ceiling which in each instance has an opening which is covered by a cover plate bearing at least one cathode and wherein the process chamber has diaphragms and supply pipelines, in particular coolant pipelines, **characterised in that** the diaphragms (17, 27, 28, 29) and supply pipelines, in particular the coolant pipelines (16), are provided on a frame (10) which projects into the process chamber (1) and is capable of being drawn out of the opening (4) in the upward direction and which is supported by supporting parts (11) on bearing surfaces (9) of the chamber ceiling (3) and **in that** the cover plate (5) projects beyond the supporting parts (11) and rests upon the chamber ceiling (3), sealing directly from above.

2. Device according to Claim 1, **characterised in that** the bearing surfaces (9) within the opening (4) are provided by gradations (8) within two marginal regions each delimiting the opening (4) on a longitudinal side.

3. Device according to Claim 1 or 2, **characterised in that** on one longitudinal side the frame (10) has an extension arm (12) engaging via the process chamber (1) with supply ports (13) at least for coolant.

4. Device according to Claim 3, **characterised in that** the supply ports (13) are directed downwards and coolant feed ports (14) aligned with the supply ports (13) of the extension arm (12) are disposed on the outside of the process chamber (1).

5. Device according to at least one of the preceding claims, **characterised in that** the diaphragms (17, 27, 28, 29) have cooling-water pipes (30) that are capable of being connected to the coolant.

6. Device according to Claim 5, **characterised in that** the diaphragms (28) are of box-shaped design and have regions extending between two conveyor rollers (25, 32) close to the circumferential surfaces of said conveyor rollers.

7. Device according to at least one of the preceding claims, **characterised in that** the frame (10) exhibits on the side of the extension arm (12) a supply space (15) in communication with the atmosphere and sealed in the direction of the process chamber (1), in which the coolant pipelines (16) serving for the coolant connection to the diaphragms (17, 27, 28, 29) are disposed.

8. Device according to at least one of the preceding claims, **characterised in that** the frame (10) is sealed by pinch-type seals (31) close to the diaphragms (17, 27, 28, 29) on its underside in relation to a false bottom (24) of the process chamber (1).

9. Device according to at least one of the preceding claims, **characterised in that** the cover plate (5) has gas pipes (18) for the feed of the process gas and gas ports (19) engaging via the process chamber (1) and **in that** on the outside the process chamber (1) has gas-feed ports (20) in alignment with the gas ports (19).

10. Device according to at least one of the preceding claims, **characterised in that** the frame (10) is mechanically coupled to the cover plate (5) of the cathode array (6).

## Revendications

1. Dispositif de revêtement de substrats en forme de plaque par pulvérisation cathodique, lequel a plusieurs chambres de traitement les unes derrière les autres qui sont chacune limitée vers le haut par un plafond de chambre, possédant à chaque fois une ouverture, laquelle est recouverte par un couvercle portant au moins une cathode ; dans lequel la chambre de traitement comporte des diaphragmes et des conduites d'alimentation, en particulier des conduites de réfrigérant ; **caractérisé en ce que** les diaphragmes (17, 27, 28, 29) et les conduites d'alimentation, en particulier les conduites de réfrigérant (16), sont prévus sur un bâti (10) pénétrant dans la chambre de traitement (1), extractible par le haut hors l'ouverture (4) et qui s'appuie à l'aide de parties de soutien (11) contre les surfaces d'appui (9) du plafond de chambre (3), et **en ce que** le couvercle (5) dépasse au-delà des parties de soutien (11) et repose depuis le haut directement et avec étanchement sur le plafond de chambre (3).

2. Dispositif selon la revendication 1, **caractérisé en ce que** les surfaces d'appui (9) sont prévues à l'intérieur de l'ouverture (4) au moyen de gradins (8) à l'intérieur de deux zones de bordure qui délimitent respectivement l'ouverture (4) sur le côté longitudinal.

3. Dispositif selon l'une ou l'autre des revendications 1 et 2, **caractérisé en ce que** le bâti (10) possède sur un côté longitudinal un bras (12) coiffant la chambre de traitement (1) avec des raccords d'alimentation (13) au moins pour du réfrigérant.

4. Dispositif selon la revendication 3, **caractérisé en ce que** les raccords d'alimentation (13) sont orientés vers le bas et les raccords d'amenée de réfrigérants (14) sont agencés à l'extérieur de la chambre de traitement (1), lesquels sont alignés avec les raccords d'alimentation (13) du bras (12).

5. Dispositif selon l'une au moins des revendications précédentes, **caractérisé en ce que** les diaphragmes (17, 27, 28, 29) présentent des tubes d'eau de refroidissement (30) susceptibles d'être raccordés au réfrigérant.

6. Dispositif selon la revendication 5, **caractérisé en ce que** les diaphragmes (28) sont réalisés en forme de caisson et comportent entre deux rouleaux de transport (25, 32) des zones qui s'étendent au voisinage des surfaces enveloppe de ces rouleaux transport.

7. Dispositif selon l'une au moins des revendications précédentes, **caractérisé en ce que** le bâti (10) présente sur le côté du bras (12) une chambre d'alimentation (15) communicant avec l'atmosphère et refermée en direction de la chambre de traitement (1), chambre d'alimentation dans laquelle sont agencées les conduites de réfrigérant (16) servant à la communication du réfrigérant vers les diaphragmes (17, 27, 28, 29).

8. Dispositif selon l'une au moins des revendications précédentes, **caractérisé en ce que** le bâti (10) est rendu étanche à proximité des diaphragmes (17, 27, 28, 29) sur son côté inférieur vis-à-vis d'un plancher intermédiaire (24) de la chambre de traitement (1) par des joints à écrasement (31).

9. Dispositif selon l'une au moins des revendications précédentes, **caractérisé en ce que** le couvercle (5) dispose de tubes à gaz (18) pour l'amenée du gaz de traitement et de raccords de gaz (19) coiffant la chambre de traitement (1), et **en ce que** la chambre de traitement (1) comporte à l'extérieur des raccords d'amenée de gaz (20) alignés avec les raccords à gaz.

10. Dispositif selon l'une au moins des revendications précédentes, **caractérisé en ce que** le bâti (10) est couplé mécaniquement avec le couvercle (5) de l'agencement de cathode (6).
